(19)

Europäisches
Patentamt

European
Patent Office

Office européen
des brevets

(11) **EP 4 489 316 A1**

(12) **EUROPEAN PATENT APPLICATION**

(43) Date of publication:
**08.01.2025 Bulletin 2025/02**

(21) Application number: **23184235.2**

(22) Date of filing: **07.07.2023**

(51) International Patent Classification (IPC):
**H03M 13/13** $^{(2006.01)}$

(52) Cooperative Patent Classification (CPC):
**H03M 13/13**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Nokia Technologies Oy**
**02610 Espoo (FI)**

(72) Inventors:
- **COSKUN, Mustafa Cemil**
  **New Providence, NJ, 07974 (US)**
- **DU, Jinfeng**
  **West Windsor, NJ, 08550 (US)**

(74) Representative: **Laine IP Oy**
**Porkkalankatu 24**
**00180 Helsinki (FI)**

(54) **NESTED SEQUENCES FOR POLAR CODES**

(57)    According to an example aspect of the present invention, there is provided encode or decode data using a polar code, wherein a generator matrix of the polar code is comprised of rows of a polar transform matrix $G_N = B_N G_2^{\otimes n}$, where $B_N$ ;is an $N \times N$ bit-reversal matrix, where $N = 2^n$ is a non-negative integer and where $G_2^{\otimes n}$ is an n-fold Kronecker product of $G_2 \triangleq \begin{bmatrix} 1 & 0 \\ 1 & 1 \end{bmatrix}$, a set of indices of rows of the polar transform matrix which form the generator matrix being set A.

Encoding or decoding data using a polar code (N, K) wherein a generator matrix of the polar code  is comprised of rows of a polar transform matrix $\mathbf{G_N}$    — 510

Generating set A for the polar code by first selecting from vector $r_{Nmax}$ each element not greater than N    — 520

Obtaining set A by selecting the K last elements from vector r    — 530

**FIGURE 5**

EP 4 489 316 A1

**Description**

FIELD

The present disclosure relates to the field of channel coding, such as channel coding for wireless communication systems, such as cellular wireless communication systems, for example.

BACKGROUND

Information to be transmitted, known as payload, may be encoded prior to transmission over a transmission channel. This encoding, which may be referred to as error correction coding or channel coding, may facilitate use of a noisy communication channel to convey payload which tolerates no errors, or fewer errors than would occur over the communication channel without the use of encoding.

Typically, when the payload bit sequence is encoded, the result is an encoded bit sequence which is longer than the original payload bit sequence, as redundancy information is provided in the encoded bit sequence in addition to payload. An extent of redundancy information may be associated with an extent of error detection or error correction that is possible. In case errors are merely detected with channel coding, an information block with a detected error may be requested to be re-transmitted, to overcome the detected error.

SUMMARY

According to some aspects, there is provided the subject-matter of the independent claims. Some embodiments are defined in the dependent claims. The scope of protection sought for various embodiments of the invention is set out by the independent claims. The embodiments, examples and features, if any, described in this specification that do not fall under the scope of the independent claims are to be interpreted as examples useful for understanding various embodiments of the invention.

According to a first aspect of the present disclosure, there is provided an apparatus comprising at least one processing core and at least one memory storing instructions that, when executed by the at least one processing core, cause the apparatus at least to encode or decode data using a polar code, wherein a generator matrix of the polar code is comprised of rows of a polar transform matrix $G_N = B_N G_2^{\otimes n}$, where $B_N$; is an N $\times$ N bit-reversal matrix, where N = 2" is a non-negative integer and where $G_2^{\otimes n}$ is an n-fold Kronecker product of $G_2 \triangleq \begin{bmatrix} 1 & 0 \\ 1 & 1 \end{bmatrix}$, a set of indices of rows of the polar transform matrix which form the generator matrix being set A, wherein at least one of the following applies: A) for encoded length N = 64 with 44 payload bits the set A is {4, 6, 8, 12, 14, 15, 16, 20, 22, 23, 24, 26, 27, 28, 29, 30, 31, 32, 36, 38, 39, 40, 42, 43, 44, 45, 46, 47, 48, 50, 51, 52, 53, 54, 55, 56, 57, 58, 59, 60, 61, 62, 63, 64}, B) for encoded length N = 64 with 20 payload bits the set A is {16, 24, 28, 30, 31, 32, 40, 44, 46, 47, 48, 52, 54, 55, 56, 58, 60, 62, 63, 64}, and C) for encoded length N = 32 with 20 payload bits the set A is {8, 12, 14, 15, 16, 24, 28, 30, 31, 32}.

According to a second aspect of the present disclosure, there is provided an apparatus comprising at least one processing core and at least one memory storing instructions that, when executed by the at least one processing core, cause the apparatus at least to encode or decode data using a polar code, wherein a generator matrix of the polar code is comprised of rows of a polar transform matrix $G_N = B_N G_2^{\otimes n}$, where $B_N$; is an N $\times$ N bit-reversal matrix, where N = 2" is a non-negative integer and where $G_2^{\otimes n}$ is an n-fold Kronecker product of $G_2 \triangleq \begin{bmatrix} 1 & 0 \\ 1 & 1 \end{bmatrix}$, a set of indices of rows of the polar transform matrix which form the generator matrix being set A, wherein the apparatus is configured to generate set A for the polar code with N encoded bits, N not greater than 128, and K payload bits as follows: select from vector $r_{N_{max}}$ = [1, 65, 33, 17, 9, 5, 3, 2, 97, 81, 73, 69, 67, 66, 49, 41, 37, 35, 34, 25, 21, 19, 18, 13, 11, 10, 7, 6, 4, 113, 105, 101, 99, 98, 89, 85, 83, 82, 77, 75, 74, 71, 70, 68, 57, 53, 51, 50, 45, 43, 42, 39, 38, 36, 29, 27, 26, 23, 22, 20, 15, 14, 12, 8, 121, 117, 115, 114, 109, 107, 106, 103, 102, 100, 93, 91, 90, 87, 86, 84, 79, 78, 76, 72, 61, 59, 58, 55, 54, 52, 47, 46, 44, 40, 31, 30, 28, 24, 16, 125, 123, 122, 119, 118, 116, 111, 110, 108, 104, 95, 94, 92, 88, 80, 63, 62, 60, 56, 48, 32, 127, 126, 124, 120, 112, 96, 64, 128] each element not greater than N to thereby obtain, while maintaining the order of the selected elements, vector r, and obtain set A by selecting the K last elements from vector r.

According to a third aspect of the present disclosure, there is provided a method comprising encoding or decoding data using a polar code, wherein a generator matrix of the polar code is comprised of rows of a polar transform matrix $G_N = B_N G_2^{\otimes n}$, where $B_N$; is an N $\times$ N bit-reversal matrix, where N = 2^n is a non-negative integer and where

$G_2^{\otimes n}$ is an n-fold Kronecker product of $G_2 \triangleq \begin{bmatrix} 1 & 0 \\ 1 & 1 \end{bmatrix}$, a set of indices of rows of the polar transform matrix which form the generator matrix being set A, wherein at least one of the following applies: A) for encoded length N = 64 with 44 payload bits the set A is {4, 6, 8, 12, 14, 15, 16, 20, 22, 23, 24, 26, 27, 28, 29, 30, 31, 32, 36, 38, 39, 40, 42, 43, 44, 45, 46, 47, 48, 50, 51, 52, 53, 54, 55, 56, 57, 58, 59, 60, 61, 62, 63, 64}, B) for encoded length N = 64 with 20 payload bits the set A is {16, 24, 28, 30, 31, 32, 40, 44, 46, 47, 48, 52, 54, 55, 56, 58, 60, 62, 63, 64}, and C) for encoded length N = 32 with 20 payload bits the set A is {8, 12, 14, 15, 16, 24, 28, 30, 31, 32}.

According to a fourth aspect of the present disclosure, there is provided a method, comprising encoding or decoding data using a polar code, wherein a generator matrix of the polar code is comprised of rows of a polar transform matrix $G_N = B_N G_2^{\otimes n}$, where $B_N$; is an N × N bit-reversal matrix, where N = 2^n is a non-negative integer and where $G_2^{\otimes n}$ is an n-fold Kronecker product of $G_2 \triangleq \begin{bmatrix} 1 & 0 \\ 1 & 1 \end{bmatrix}$, a set of indices of rows of the polar transform matrix which form the generator matrix being set A, wherein the apparatus is configured to generate set A for the polar code with N encoded bits, N not greater than 128, and K payload bits as follows: select from vector $r_{Nmax}$ = [1, 65, 33, 17, 9, 5, 3, 2, 97, 81, 73, 69, 67, 66, 49, 41, 37, 35, 34, 25, 21, 19, 18, 13, 11, 10, 7, 6, 4, 113, 105, 101, 99, 98, 89, 85, 83, 82, 77, 75, 74, 71, 70, 68, 57, 53, 51, 50, 45, 43, 42, 39, 38, 36, 29, 27, 26, 23, 22, 20, 15, 14, 12, 8, 121, 117, 115, 114, 109, 107, 106, 103, 102, 100, 93, 91, 90, 87, 86, 84, 79, 78, 76, 72, 61, 59, 58, 55, 54, 52, 47, 46, 44, 40, 31, 30, 28, 24, 16, 125, 123, 122, 119, 118, 116, 111, 110, 108, 104, 95, 94, 92, 88, 80, 63, 62, 60, 56, 48, 32, 127, 126, 124, 120, 112, 96, 64, 128] each element not greater than N to thereby obtain, while maintaining the order of the selected elements, vector r, and obtain set A by selecting the K last elements from vector r.

According to a fifth aspect of the present disclosure, there is provided an apparatus comprising means for encoding or decoding data using a polar code, wherein a generator matrix of the polar code is comprised of rows of a polar transform matrix $G_N$ = $B_N G_2^{\otimes n}$, where $B_N$; is an N × N bit-reversal matrix, where N = 2^n is a non-negative integer and where $G_2^{\otimes n}$ is an n-fold Kronecker product of $G_2 \triangleq \begin{bmatrix} 1 & 0 \\ 1 & 1 \end{bmatrix}$, a set of indices of rows of the polar transform matrix which form the generator matrix being set A, wherein at least one of the following applies: A) for encoded length N = 64 with 44 payload bits the set A is {4, 6, 8, 12, 14, 15, 16, 20, 22, 23, 24, 26, 27, 28, 29, 30, 31, 32, 36, 38, 39, 40, 42, 43, 44, 45, 46, 47, 48, 50, 51, 52, 53, 54, 55, 56, 57, 58, 59, 60, 61, 62, 63, 64}, B) for encoded length N = 64 with 20 payload bits the set A is {16, 24, 28, 30, 31, 32, 40, 44, 46, 47, 48, 52, 54, 55, 56, 58, 60, 62, 63, 64}, and C) for encoded length N = 32 with 20 payload bits the set A is {8, 12, 14, 15, 16, 24, 28, 30, 31, 32}.

According to a sixth aspect of the present disclosure, there is provided a non-transitory computer readable medium having stored thereon a set of computer readable instructions that, when executed by at least one processor, cause an apparatus to at least encode or decode data using a polar code, wherein a generator matrix of the polar code is comprised of rows of a polar transform matrix $G_N = B_N G_2^{\otimes n}$, where $B_N$; is an N × N bit-reversal matrix, where N = 2^n is a non-negative integer and where $G_2^{\otimes n}$ is an n-fold Kronecker product of $G_2 \triangleq \begin{bmatrix} 1 & 0 \\ 1 & 1 \end{bmatrix}$, a set of indices of rows of the polar transform matrix which form the generator matrix being set A, wherein at least one of the following applies: A) for encoded length N = 64 with 44 payload bits the set A is {4, 6, 8, 12, 14, 15, 16, 20, 22, 23, 24, 26, 27, 28, 29, 30, 31, 32, 36, 38, 39, 40, 42, 43, 44, 45, 46, 47, 48, 50, 51, 52, 53, 54, 55, 56, 57, 58, 59, 60, 61, 62, 63, 64}, B) for encoded length N = 64 with 20 payload bits the set A is {16, 24, 28, 30, 31, 32, 40, 44, 46, 47, 48, 52, 54, 55, 56, 58, 60, 62, 63, 64}, and C) for encoded length N = 32 with 20 payload bits the set A is {8, 12, 14, 15, 16, 24, 28, 30, 31, 32}.

BRIEF DESCRIPTION OF THE DRAWINGS

FIGURE 1 illustrates an example system in accordance with at least some embodiments of the present invention;

FIGURE 2A illustrates an example encoding process;

FIGURE 2B illustrates an example encoding process;

FIGURE 2C illustrates an example encoding process;

FIGURE 3 illustrates an example apparatus capable of supporting at least some embodiments of the present invention;

FIGURE 4 illustrates simulation results, and

FIGURE 5 is a flow graph of a method in accordance with at least some embodiments of the present invention.

EMBODIMENTS

By employing a polar code-based channel coding solution as herein described, advantageously communication of information in a communication system may be achieved using less energy per bit than in earlier solutions. Further, the polar codes herein described may be employed using less memory than in at least some other polar code solutions. The channel coding solution may be used with 3GPP radio-access technologies, such as 5G, and a successive cancellation list decoding process, for example.

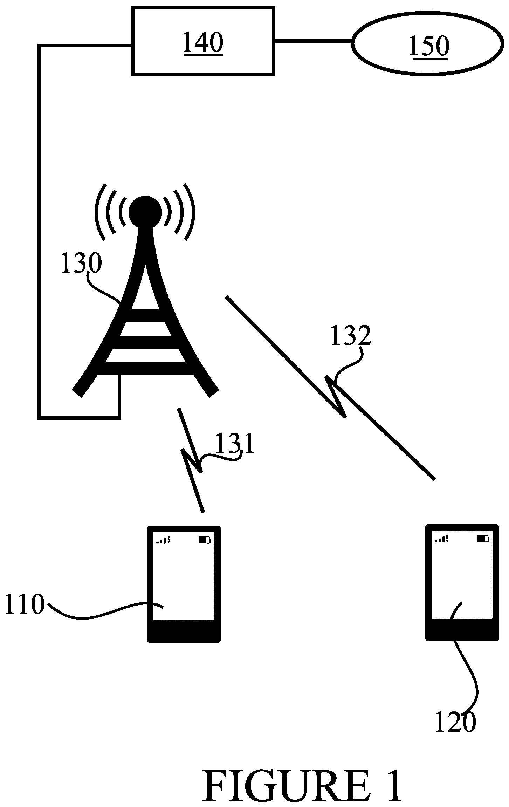

FIGURE 1 illustrates an example system in accordance with at least some embodiments of the present disclosure. This system includes a base station 130 in communication with UEs 110, 120. Radio link 131 connects base station 130 with UE 110, and radio link 132 connects base station 130 with UE 120. The radio links 131, 132 may be bidirectional, comprising an uplink, UL, to convey information from the respective UE 110, 120 toward the base station 130 and a downlink, DL, to convey information from the base station 130 toward the respective UE 110, 120.

Base station 130 is further coupled communicatively with core network node 140, which may comprise, for example, a mobility management entity, MME, or access and mobility management function, AMF. The core network node 140 may be coupled with further core network nodes, and with a network 150, which may comprise the Internet or a corporate network, for example. The system may communicate with further networks via network 150. Examples of the further core network nodes, which are not illustrated in FIGURE 1 for the sake of clarity, include gateways and subscriber information repositories.

Radio links 131, 132 may be in accordance with a long-term evolution, LTE, technology, or a new radio, NR, technology, which is also known as fifth generation, 5G, for example. In particular, radio links 131, 132 comprise a set of subbands, each subband being a frequency resource in use between the base station and UE. There may be, for example, up to 12 or up to 18 subbands. There may be more than 18 subbands. The subbands in the set of subbands may form a contiguous block of subbands in frequency space, for example.

Information transmitted on radio links 131, 132 may be encoded using a suitable channel coding solution, such as a polar code-based channel coding solution. Thus a payload bit sequence, which is to be communicated in the uplink or downlink, is transformed into an encoded bit sequence prior to transmission over radio link 131 or 132. The encoded bit sequence is longer than the payload bit sequence since the encoded bit sequence includes redundancy information usable in recovering the payload bit sequence also in case bit errors are incurred during transmission. For example wireless channels experience noise and fading, which may result in unpredictable gaps in reception of modulation symbols at the receiver end, and channel coding which enables correction, or at least detection, of such errors is of considerable use when the payload bit sequence is of a type which does not tolerate errors.

Payload bit sequences may be of different types with differing requirements. For example, isolated bit errors may be acceptable in streaming video content or conversational voice calls. On the other hand when transmitting network control information or software updates, for example, bit errors should be corrected after reception, or the affected block should be re-transmitted to communicate the exact payload bit sequence to the receiver. A channel coding solution may be dynamically selected based on characteristics of the payload data to be transmitted. A polar code based channel coding solution may be particularly useful in communicating relatively brief payload bit sequences, such as network control information, for example. Network control information may be provided to the receiver using a control channel, such as a physical uplink control channel, PUCCH or a physical downlink control channel, PDCCH, of system based on a radio-access technology, RAT, specified by the 3$^{rd}$ Generation Partnership Project, 3GPP.

Polar codes, in particular, are a family of capacity-achieving error-correcting codes, ECC. Their modification via outer cyclic redundancy check, CRC, codes has been endorsed by the 3GPP as channel coding for control channels in fifth generation, 5G. Other modifications of polar codes, such as, polarization-adjusted convolutional, PAC, codes, where they can be seen as polar codes with dynamic frozen bits, have been shown to be effective in short to medium-length payload bit sequence regime under near maximum-likelihood, ML, decoding. Prominent examples of near-MI, decoding algorithms include successive cancellation list, SCL decoding and successive cancellation ordered search, SCOS. By frozen bits it is meant locations where zero-padding adds zeroes to lengthen the payload bit sequence for channel coding. The payload bits are placed in the zero-padded bit sequence to bit locations which are not the frozen bits.

Polar codes have been included in the 5G wireless communication standard for their promising performance in particular when communicating short payload bit sequences. Examples of short bit sequences include 40 payload bits and 20 payload bits. This performance is achieved by combinations of the following two ingredients: code design and use of a near-ML decoding algorithm. The former may consist of the selection of the so-called frozen bit indices and an outer CRC code as for 5G polar codes. Another alternative consists of the selection of the frozen bit indices and the constraints on the selected frozen bit positions, which may be defined by an upper-triangular precoding matrix, for example. In either case, the code provides good performance under low-complexity decoding algorithms in mind.

A decoding algorithm well suited for polar codes is successive cancellation list, SCL, decoding, which runs L parallel successive cancellation, SC, decoding instances. At each instance, there is a hypothesis, called a path, on the values of the processed bits up to the current decoding stage. Whenever the number of paths exceed the list size L, then the decoder is configured to prune the list to keep the L most likely paths for the next stage. Increasing L provides a better error-correcting capability, at the expense of higher complexity in the decoder. Therefore, codes performing better for a given fixed list size are of interest, and described in the present disclosure.

It has been observed that 5G CRC-aided polar codes require large list sizes to provide near-optimum decoding, especially when the payload bit sequences or encoded bit sequences are short due to long CRCs adopted in the standard. This calls for a search for a selection of the polar code solutions which provide a better performance versus complexity trade-off for SCL decoding.

A specific polar code may be identified as follows. Let $\boldsymbol{B}_N$ denote an $N \times N$ bit-reversal matrix, where $N = 2^n$ with $n$ being a non-negative integer, and let $\boldsymbol{G}_2 \triangleq \begin{bmatrix} 1 & 0 \\ 1 & 1 \end{bmatrix}$. Consider the matrix $\boldsymbol{G}_N = \boldsymbol{B}_N \boldsymbol{G}_2^{\otimes n}$ where $\boldsymbol{G}_2^{\otimes n}$ is the n-fold Kronecker product of $\boldsymbol{G}_2$. Here $\boldsymbol{G}_N$ may be referred to as a polar transform matrix. Considering, first, all the codes whose generator matrix is formed by choosing $K$ rows from $\boldsymbol{G}_N$. These selected row indices are referred to as information indices and the set containing the information indices is denoted as $\mathcal{A}$. For instance, an $(N, K)$ polar code is obtained by storing the $K$ indices $i \in \{1, 2,..., N\}$, which provides best performance under successive cancellation, SC, decoding, that is, the most reliable $K$ indices are chosen. In an (N, K) code, N is the length of the encoded bit sequence, and K is the length of the payload bit sequence. Another relevant code which may be generated from $\boldsymbol{G}_N$ is an $r$-th order Reed-Muller, RM, code of length $N$ and dimension $K \triangleq \sum_{i=0}^{r} \binom{n}{i}$ with $0 \le r \le n$. In this case, the set $\mathcal{A}$ consists of the indices $i \in 1, 2, ... , N$, corresponding to the rows of $\boldsymbol{G}_N$ with the Hamming weight at least equal to $2^{n-r}$. Suppose that $\boldsymbol{v}$ denotes the $K$-bit message to be encoded, that is, the payload bit sequence. In other words, K is the length of the payload bit sequence. In both cases, encoding is performed via applying polar transform after a suitable zero-padding to the message, that is, the codeword $\boldsymbol{c}$ is obtained as $\boldsymbol{c} = \boldsymbol{u}\boldsymbol{G}_N$ where $\boldsymbol{u}$ is a length-$N$ binary vector with $\boldsymbol{u}_{\mathcal{F}} = \boldsymbol{0}$ is the subvector of $\boldsymbol{u}$ with the elements of indices in set $\mathcal{F} \triangleq \{1, 2, ... , N\} \backslash \mathcal{A}$ and $\boldsymbol{u}_{\mathcal{A}} = \boldsymbol{v}$. Note that the set $\mathcal{A}$ (hence $\mathcal{F}$) is known to the receiver. F comprises the input positions which are set to known values and provided to the receiver, namely the index set for frozen bits in the polar code literature.

There are various alternative methods to choose set $\mathcal{A}$. A first method is to choose $\mathcal{A}$ so that an upper bound on the block error probability, BLEP, is minimized. This method provides a theoretical framework for constructing nested polar codes for arbitrary block length $N$ and the message length $K$. Such methods to choose $\mathcal{A}$ do not take into account a distance spectrum of the resulting construction. Using RM-polar codes to address this aspect may be accomplished as follows. Supposing that the aim is to design an $(N, K)$ polar code. We first find the information set $\mathcal{A}_{RM}$ of the lowest rate RM code, which has a larger dimension than $K$. Then, the $K$ most reliable positions in $\mathcal{A}_{RM}$ constitutes the desired set $\mathcal{A}$. In this way, the resulting code's minimum distance is guaranteed to be more than or equal to that of the considered higher rate RM code. At the same time, it is well-suited for SCL decoding.

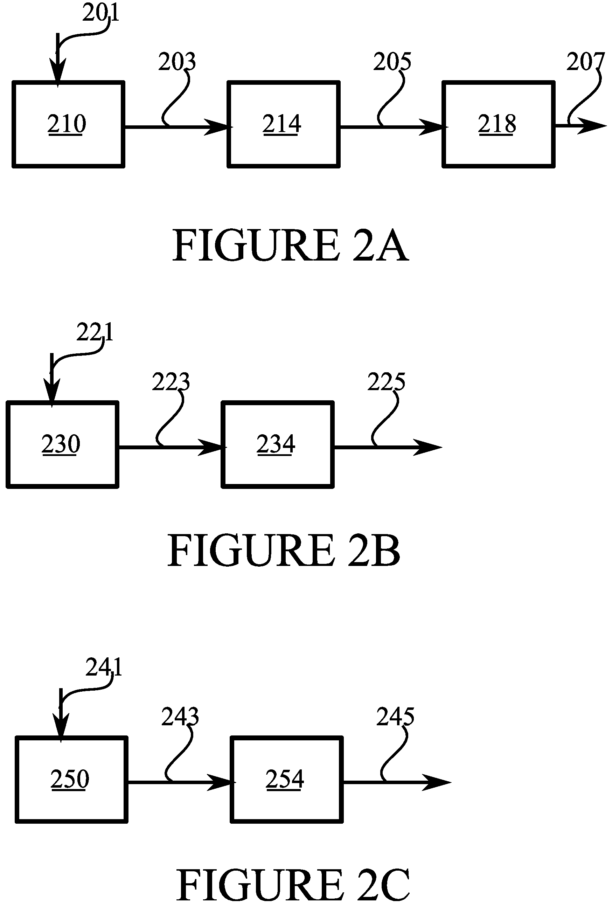

The method described above relates to choosing set $\mathcal{A}$ for specifying a polar code. A concatenated scheme as illustrated in FIGURE 2A may be used to improve a distance spectrum of the underlying polar code significantly by using an outer code. In this case, the K-bit message 201 is first encoded via an outer $(K + -\ell, K)$ code 210, which adds $\ell$-bit redundancy to the message resulting in a bit vector 203 of length $K + \ell$. Then, the bit vector is encoded via an inner $(N, K + \ell)$ polar code 218 defined by set $\mathcal{A}$, by placing $\boldsymbol{u}_{\mathcal{A}} = \boldsymbol{v}'$. The outer code may adopt systematic or non-systematic encoding. One example is to adopt a CRC code as the outer code with systematic encoding. These parity checks may be mapped to the bits corresponding to the last $\ell$ positions of the inner polar code, or they may be distributed with a suitable modification of the outer code which is called parity-check-concatenated, PCC, polar codes.

FIGURE 2A illustrates an example encoding process. A K-bit length payload bit sequence 201 is provided into outer encoder 210, which outputs an encoded bit vector of length $K + \ell$ 203, termed $u_A$. This is provided into a zero-padding phase 214, which in turn outputs an N-bit vector 205. This vector 205 is provided to a polar transform $\boldsymbol{G}_N$ 218, whence an N-bit codeword 207 is obtained.

Another approach is to apply an $N \times N$ upper unitriangular (that is, an upper-triangular matrix where the main diagonal entries are all 1) and invertible pre-transformation matrix $\boldsymbol{T}$ before applying polar transform $\boldsymbol{G}_N$. In this approach, the outer code can be skipped or kept. FIGURE 2B illustrates this block diagram, where the outer code is skipped. The encoding is performed via $c = uTG_N$ where $u_{\mathcal{F}} = 0$ and $u_{\mathcal{A}} = v$. This approach can be also described as polar codes with dynamic frozen bits, where the frozen bit values are not equal to zeros for all frozen bits. Instead, they may be parity checks described by the pre-transformation matrix $T$. An alternative name for such polar codes are called pre-transformed, PT, polar codes. An important class includes the polarization-adjusted convolutional, PAC, codes, where matrix $T$ is restricted to be a Toeplitz matrix and one row is enough for description as the other rows are just cyclic shifts of the row. This approach has been extended to time-varying rows. A Toeplitz matrix, or diagonal-constant matrix, named after Otto Toeplitz, is a matrix in which each descending diagonal from left to right is constant. Some embodiments of the polar codes disclosed herein use the Toeplitz matrix for pre-transformation.

FIGURE 2B illustrates an example encoding process. K-bit message vector 221 is input to a zero-padding phase 230, whence a zero-padded N-bit vector 223 is provided to encoder 234, where the pre-transformation matrix T is applied before polar transform $G_N$. Alternatively, a product of $T$ and $G_N$ may be applied.

An alternative representation for polar codes with dynamic frozen bits are so-called pre-coded polar codes, illustrated as FIGURE 2C. In this case, the blocks corresponding to zero padding and transformation $T$ can be combined to provide a $K \times N$ precoding matrix $P$, 250, which results in the block diagram given in FIGURE 2C. The column index of the first "1" in each row of matrix $P$ is an element of $\mathcal{A}$. The collection of all such column indices forms set $\mathcal{A}$. In other words, given the pre-coding matrix $P$ 250, one can find the corresponding set $\mathcal{A}$.

FIGURE 2C illustrates an example encoding process. K-bit message vector 241 is input to a pre-transformation phase 250, where precoding matrix $P$ is applied whence a zero-padded N-bit vector 243 is provided to encoder 254, where a polar transform $G_N$ is applied.

In the three illustrated cases with different block diagrams, FIGUREs 2A, 2B and 2C, the choice of set $\mathcal{A}$ is key for both the BLEP and the required decoding complexity to achieve that BLEP.

Herein is described a polar code design and selection method. Supposing that it is aimed to design an (N, K) polar code, that is, the output of the procedure is the set $\mathcal{A}$ of size K. To this end, let $r^{(M)}$ and $r^{(S)}$ be the smallest and largest integers, respectively, such that $K^{(M)} \triangleq \sum_{i=0}^{r^{(M)}} \binom{log_2 N}{i} \geq K \geq \sum_{i=0}^{r^{(S)}} \binom{log_2 N}{i} = K^{(S)}$. Let $\mathcal{A}^{(M)}$ and $\mathcal{A}^{(S)}$ denote the sets containing the information indices of the length-A RM codes of orders $r^{(M)}$ and $r^{(S)}$, respectively. In fact, we have the relation $\mathcal{A}^{(S)} \subset \mathcal{A}^{(M)}$. Then, a set may be defined $\mathcal{A}^{(M \backslash S)} \triangleq \{a_1, a_2, ..., a_{K(M)-K(S)}\}$ with $a_i \leq a_j$ if $i \leq j$. Then, the set containing the information positions of the proposed codes are given as $\mathcal{A} = \mathcal{A}^{(S)} \cup \{a_1, a_2, ..., a_{K-K(S)}\}$, that is, it is composed of the information positions of the lower-rate RM code of length-$N$ and order $r^{(S)}$ and $K - K^{(S)}$ smallest indices of the set difference $\mathcal{A}^{(M \backslash S)}$. By acting so, it may be guaranteed that the minimum distance of the resulting code is lower-bounded by that of the RM code of length-$N$ and order $r^{(M)}$, that is, the same as that of an RM-polar code. In addition, this choice is expected to enhance the performance of the resulting code when combined with any upper unitriangular pre-transformation matrix $T$ compared to the RM-polar code of the same parameters.

In the following, the difference in frozen/information bit indices for parameters $K = 44$ and $N = 64$ according to construction proposed by 5G standard, RM-polar and the proposed method is explored in tabular forms. In the tables, the position of a 1 corresponds to a frozen bit index and that of a 0 to an information bit index, that is, the indices of zeroes, if stored in a set, return the corresponding set $\mathcal{A}$. Also, the counting starts from the top left corner and continues row-wise, that is, the index of the first entry in the second row is 33. In addition, the indices for length-64 RM codes of orders $r^{(M)} = 4$ and $r^{(S)} = 3$ are provided, which correspond to dimensions $K^{(M)} = 57$ and $K^{(S)} = 42$, respectively. In order to stress the differences in the indices compared to the (64,42) RM code, they are highlighted with a **bold-face** font in the tables. The ordered difference set is constructed as $\mathcal{A}^{(M \backslash S)} = \{4,6,7,10,11,13,18,19,21,25,34,35,37,41,49\}$. Then, the information indices of the proposed construction is obtained as $\mathcal{A} = \mathcal{A}^{(S)} \cup \{a_1, a_2\}$, where $\mathcal{A}^{(S)}$ corresponds to the information bit indices of the (64,42) RM code (locations of 0s in Table I), $a_1 = 4$ and $a_2 = 6$.

| 1 | 1 | 1 | 1 | 1 | 1 | 1 | 0 | 1 | 1 | 1 | 0 | 1 | 0 | 0 | 0 | 1 | 1 | 1 | 0 | 1 | 0 | 0 | 0 | 1 | 0 | 0 | 0 | 0 | 0 | 0 | 0 |
|---|---|---|---|---|---|---|---|---|---|---|---|---|---|---|---|---|---|---|---|---|---|---|---|---|---|---|---|---|---|---|---|
| 1 | 1 | 1 | 0 | 1 | 0 | 0 | 0 | 1 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 |

Table I: information and frozen bits for (64,42) RM code

| 1 | 1 | 1 | 0 | 1 | 0 | 0 | 0 | 1 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 |
|---|---|---|---|---|---|---|---|---|---|---|---|---|---|---|---|---|---|---|---|---|---|---|---|---|---|---|---|---|---|---|---|
| 1 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 |

Table II: Information and frozen bits for the (64,57) RM code

| 1 | 1 | 1 | 0 | 1 | 0 | 1 | 0 | 1 | 1 | 1 | 0 | 1 | 0 | 0 | 0 | 1 | 1 | 1 | 0 | 1 | 0 | 0 | 0 | 1 | 0 | 0 | 0 | 0 | 0 | 0 | 0 |
|---|---|---|---|---|---|---|---|---|---|---|---|---|---|---|---|---|---|---|---|---|---|---|---|---|---|---|---|---|---|---|---|
| 1 | 1 | 1 | 0 | 1 | 0 | 0 | 0 | 1 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 |

Table III: Information and frozen bits for the proposed (64,44) code

| 1 | 1 | 1 | 1 | 1 | 1 | 1 | 1 | 1 | 1 | 1 | 0 | 1 | 0 | 0 | 0 | 1 | 1 | 1 | 0 | 1 | 0 | 0 | 0 | 1 | 0 | 0 | 0 | 0 | 0 | 0 | 0 |
|---|---|---|---|---|---|---|---|---|---|---|---|---|---|---|---|---|---|---|---|---|---|---|---|---|---|---|---|---|---|---|---|
| 1 | 1 | 1 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 |

Table IV: Information and frozen bits for the (64,44) RM-polar code

| 1 | 1 | 1 | 1 | 1 | 1 | 1 | 0 | 1 | 1 | 1 | 0 | 1 | 0 | 0 | 0 | 1 | 1 | 1 | 0 | 1 | 0 | 0 | 0 | 1 | 0 | 0 | 0 | 0 | 0 | 0 | 0 |
|---|---|---|---|---|---|---|---|---|---|---|---|---|---|---|---|---|---|---|---|---|---|---|---|---|---|---|---|---|---|---|---|
| 1 | 1 | 1 | 0 | 1 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 |

Table V: Information and frozen bits for the (64,44) polar code of 5G (without CRC)

Given a reliability sequence specified by a vector of length $r_{N_{max}}$, set $\mathcal{A}$ for a proposed code of any length $N = 2^n \leq N_{max} = 2^{n_{max}}$ and any dimension $K \leq N$ may be obtained as follows:

Firstly, store all elements of $r_{Nmax}$, which are smaller than or equal to $N$, into a subvector $r_N$ of length in the same order as the one in which they appear in the mother vector $r_{Nmax}$.

Secondly, output the vector composed the last $K$ members of $r_N$, that is, all members of $r_N[N - K + 1 : N]$, to form set $\mathcal{A}$.

The script below outputs a vector A, which is formed by the elements of set $\mathcal{A}$.

$$\text{function } A = \text{information\_set}(N, K, r_{N_{max}})$$

$$r_N = r_{N_{max}} (r_{N_{max}} < N + 1);$$

$$A = r_N (N\text{-}K\text{-}1:\text{end});$$

In the following, an algorithm to generate length $N_{max} = 2^{n_{max}}$ integer vector is provided, denoted as $r_{Nmax}$, called the reliability sequence according to the method described above with complexity of $N_{max} \log_2 N_{max}$. It takes $N_{max}$ as input and outputs $r_{Nmax}$. The herein discloses method to select set $\mathcal{A}$ is nested, that is, it results in a reliability sequence of integers starting from 1 up to a given $N_{max} = 2^{n_{max}}$, which defines set $\mathcal{A}$ (hence $\mathcal{F}$) for all possible $N$ and $K$ such that $K \leq N \leq N_{max}$. Due to the nested structure, the sets $\mathcal{A}$ for all the codes up to lengths $N_{max}$ and dimensions $K \leq N_{max}$ can be stored only via an integer vector $r_{Nmax}$ of size $N_{max}$.

$$\text{function } \boldsymbol{r}_{N_{max}} = \text{reliability\_sequence}(N_{max})$$

$$\boldsymbol{r}_{N_{max}} = \text{zeros}(1, N_{max});$$

$$\text{counter} = 0;$$

$$\text{for i=0:log2}(N_{max})$$

$$\text{for j=}N_{max}\text{:-1:1}$$

$$\text{if sum(de2bi(j-1)) == i}$$

$$\text{counter} = \text{counter} + 1;$$

$$\boldsymbol{r}_{N_{max}} (\text{counter}) = \text{j};$$

$$\text{end}$$

$$\text{end}$$

$$\text{end}$$

We provide an example with $N_{max}$ = 128, $N$ = 64 and $K$ = 44 next. The reliability sequence is found to be $\boldsymbol{r}_{N_{max}}$ = [1, 65, 33, 17, 9, 5, 3, 2, 97, 81, 73, 69, 67, 66, 49, 41, 37, 35, 34, 25, 21, 19, 18, 13, 11, 10, 7, 6, 4, 113, 105, 101, 99, 98, 89, 85, 83, 82, 77, 75, 74, 71, 70, 68, 57, 53, 51, 50, 45, 43, 42, 39, 38, 36, 29, 27, 26, 23, 22, 20, 15, 14, 12, 8, 121, 117, 115, 114, 109, 107, 106, 103, 102, 100, 93, 91, 90, 87, 86, 84, 79, 78, 76, 72, 61, 59, 58, 55, 54, 52, 47, 46, 44, 40, 31, 30, 28, 24, 16, 125, 123, 122, 119, 118, 116, 111, 110, 108, 104, 95, 94, 92, 88, 80, 63, 62, 60, 56, 48, 32, 127, 126, 124, 120, 112, 96, 64, 128]. Then, $\boldsymbol{r}_N$ = [1, 33, 17, 9, 5, 3, 2, 49, 41, 37, 35, 34, 25, 21, 19, 18, 13, 11, 10, 7, 6, 4, 57, 53, 51, 50, 45, 43, 42, 39, 38, 36, 29, 27, 26, 23, 22, 20, 15, 14, 12, 8, 61, 59, 58, 55, 54, 52, 47, 46, 44, 40, 31, 30, 28, 24, 16, 63, 62, 60, 56, 48, 32, 64] is found to be the vector consisting of all the indices in the order they appear in vector $\boldsymbol{r}_{N_{max}}$, which are smaller than or equal to $N$ = 64. The information set $\mathcal{A}$ is the last K=44 elements stored in vector $\boldsymbol{r}_N$, that is,

$A$ = {4, 6, 8, 12, 14, 15, 16, 20, 22, 23, 24, 26, 27, 28, 29, 30, 31, 32, 36, 38, 39, 40, 42, 43, 44, 45, 46, 47, 48, 50, 51, 52, 53, 54, 55, 56, 57, 58, 59, 60, 61, 62, 63, 64}.

Hence, storing the reliability sequence $\boldsymbol{r}_{Nmax}$ is sufficient to define all codes of lengths with powers of two up to the maximum block length $N_{max}$ = 128 and all possible dimensions $K \le N_{max}$, since the sets $A$ may be determined from $\boldsymbol{r}_{Nmax}$. Rather than storing all sequences $A$, they may be generated dynamically upon demand from $\boldsymbol{r}_{Nmax}$. This provides a meaningful saving in memory space required.

Simulations of the herein disclosed codes have revealed gains for length-64 codes. In these simulations, the herein disclosed polar code solutions with random pre-transformation under SCL decoding with various list sizes were compared to CRC-aided polar codes of the public 5G standard. Remarkably, the herein disclosed codes under SCL decoding with list size $L$ = 4 outperform the polar codes defined for 5G under SCL decoding with list size $L$ = 32 by around 0.25 dB at a block error rate, BLER, of $10^{-3}$ in the case of (64,20) codes. This provides the technical effect of saving energy, memory and computation cycles. In addition, the gain reaches 1.4 dB when the list sizes are fixed at $L$ = 16 for both codes. For the case of (64,44) codes, the gains are less but reaching up to 1 dB when the list sizes are fixed at $L$ = 16 for both cases.

It has further been observed that the herein disclosed polar codes under SCL decoding with sufficiently large list sizes perform very close to the respective random coding union, RCU, bound, which provides numerical indication that the herein disclosed polar codes are near-optimal for wide ranges of message and block lengths. This means that future research on the efficient decoding algorithms of the herein disclosed codes will make the herein disclosed polar codes more practical and important for longer block lengths as well.

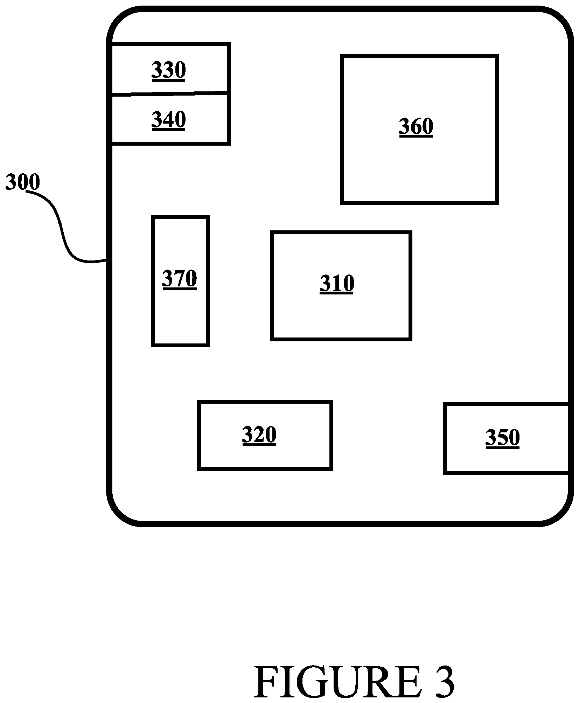

FIGURE 3 illustrates an example apparatus capable of supporting at least some embodiments of the present invention. Illustrated is device 300, which may comprise, for example, UE 110 or, in applicable parts, a base station such as those in FIGURE 1. Comprised in device 300 is processor 310, which may comprise, for example, a single- or multi-core processor wherein a single-core processor comprises one processing core and a multi-core processor comprises more than one processing core. Processor 310 may comprise, in general, a control device. Processor 310 may comprise more than one processor. When processor 310 comprises more than one processor, device 300 may be a distributed device wherein processing of tasks takes place in more than one physical unit. Processor 310 may be a control device. A processing core may comprise, for example, a Cortex-A8 processing core manufactured by ARM Holdings or a Zen processing core designed by Advanced Micro Devices Corporation. Processor 310 may comprise at least one Qualcomm Snapdragon and/or Intel Atom processor. Processor 310 may comprise at least one application-specific integrated circuit, ASIC. Processor 310 may comprise at least one field-programmable gate array, FPGA. Processor 310, memory and therein stored computer instructions may be means for performing method steps in device 300, such as encoding, decoding or obtaining, for example. Processor 310 may be configured, at least in part by computer instructions, to perform actions.

A processor may comprise circuitry, or be constituted as circuitry or circuitries, the circuitry or circuitries being configured to perform phases of methods in accordance with embodiments described herein. As used in this application, the term "circuitry" may refer to one or more or all of the following: (a) hardware-only circuit implementations, such as implementations in only analogue and/or digital circuitry, and (b) combinations of hardware circuits and software, such as, as applicable: (i) a combination of analogue and/or digital hardware circuit(s) with software/firmware and (ii) any portions of hardware processor(s) with software (including digital signal processor(s)), software, and memory(ies) that work together to cause an apparatus, such as UE or base station, to perform various functions) and (c) hardware circuit(s) and or processor(s), such as a microprocessor(s) or a portion of a microprocessor(s), that requires software (e.g., firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

Device 300 may comprise memory 320. Memory 320 may comprise random-access memory and/or permanent memory. Memory 320 may comprise at least one RAM chip. Memory 320 may be a computer readable medium. Memory 320 may comprise solid-state, magnetic, optical and/or holographic memory, for example. Memory 320 may be at least in part accessible to processor 310. Memory 320 may be at least in part comprised in processor 310. Memory 320 may be means for storing information. Memory 320 may comprise computer instructions that processor 310 is configured to execute. When computer instructions configured to cause processor 310 to perform certain actions are stored in memory 320, and device 300 overall is configured to run under the direction of processor 310 using computer instructions from memory 320, processor 310 and/or its at least one processing core may be considered to be configured to perform said certain actions. Memory 320 may be at least in part comprised in processor 310. Memory 320 may be at least in part external to device 300 but accessible to device 300. Memory 320 may be transitory or non-transitory. The term "non-transitory", as used herein, is a limitation of the medium itself (that is, tangible, not a signal) as opposed to a limitation on data storage persistency (for example, RAM vs. ROM).

Device 300 may comprise a transmitter 330. Device 300 may comprise a receiver 340. Transmitter 330 and receiver 340 may be configured to transmit and receive, respectively, information in accordance with at least one cellular or non-cellular standard. Transmitter 330 may comprise more than one transmitter. Receiver 340 may comprise more than one receiver. Transmitter 330 and/or receiver 340 may be configured to operate in accordance with global system for mobile communication, GSM, wideband code division multiple access, WCDMA, 5G, long term evolution, LTE, IS-95, wireless local area network, WLAN, Ethernet and/or worldwide interoperability for microwave access, WiMAX, standards, for example.

Device 300 may comprise a near-field communication, NFC, transceiver 350. NFC transceiver 350 may support at least one NFC technology, such as NFC, Bluetooth, Wibree or similar technologies.

Device 300 may comprise user interface, UI, 360. UI 360 may comprise at least one of a display, a keyboard, a touchscreen, a vibrator arranged to signal to a user by causing device 300 to vibrate, a speaker or a microphone. A user may be able to operate device 300 via UI 360, for example to accept incoming telephone calls, to originate telephone calls or video calls, to browse the Internet, to manage digital files stored in memory 320 or on a cloud accessible via transmitter 330 and receiver 340, or via NFC transceiver 350, and/or to play games.

Device 300 may comprise or be arranged to accept a user identity module 370. User identity module 370 may comprise, for example, a subscriber identity module, SIM, card installable in device 300. A user identity module 370 may comprise information identifying a subscription of a user of device 300. A user identity module 370 may comprise cryptographic information usable to verify the identity of a user of device 300 and/or to facilitate encryption of communicated information and billing of the user of device 300 for communication effected via device 300.

Processor 310 may be furnished with a transmitter arranged to output information from processor 310, via electrical leads internal to device 300, to other devices comprised in device 300. Such a transmitter may comprise a serial bus transmitter arranged to, for example, output information via at least one electrical lead to memory 320 for storage therein. Alternatively to a serial bus, the transmitter may comprise a parallel bus transmitter. Likewise processor 310 may comprise a receiver arranged to receive information in processor 310, via electrical leads internal to device 300, from other devices comprised in device 300. Such a receiver may comprise a serial bus receiver arranged to, for example, receive information via at least one electrical lead from receiver 340 for processing in processor 310. Alternatively to a serial bus, the receiver may comprise a parallel bus receiver.

Device 300 may comprise further devices not illustrated in FIGURE 3. For example, where device 300 comprises a smartphone, it may comprise at least one digital camera. Some devices 300 may comprise a back-facing camera and a front-facing camera, wherein the back-facing camera may be intended for digital photography and the front-facing camera for video telephony. Device 300 may comprise a fingerprint sensor arranged to authenticate, at least in part, a user of device 300. In some embodiments, device 300 lacks at least one device described above. For example, some devices 300, such as base stations, may lack a NFC transceiver 350 and/or user identity module 370.

Processor 310, memory 320, transmitter 330, receiver 340, NFC transceiver 350, UI 360 and/or user identity module 370 may be interconnected by electrical leads internal to device 300 in a multitude of different ways. For example, each of the aforementioned devices may be separately connected to a master bus internal to device 300, to allow for the devices to exchange information. However, as the skilled person will appreciate, this is only one example and depending on the embodiment various ways of interconnecting at least two of the aforementioned devices may be selected without departing from the scope of the present invention.

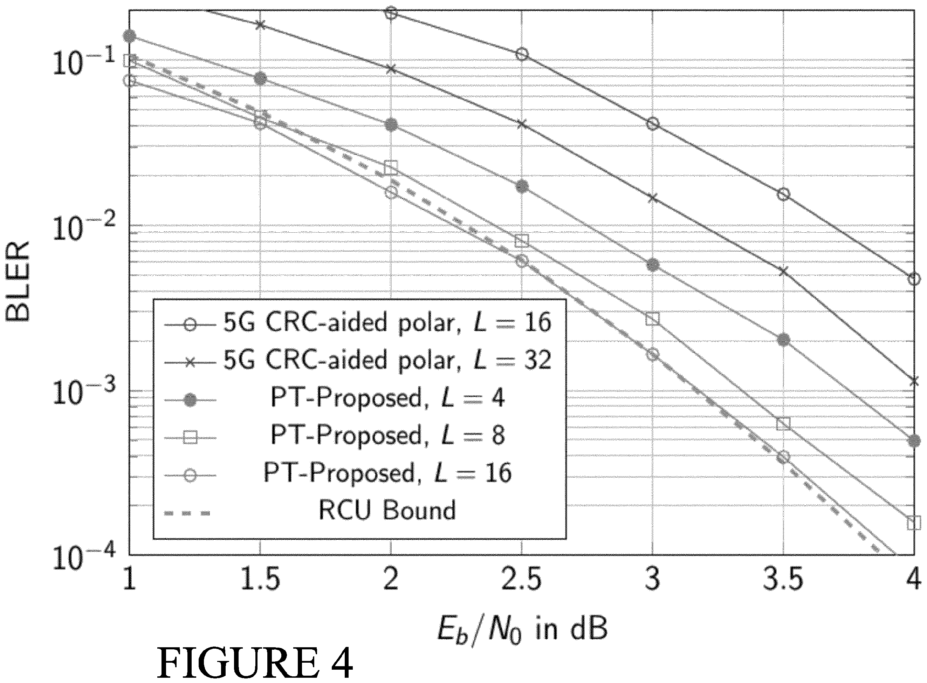

FIGURE 4 illustrates simulation results. In this simulation, BLER vs $E_b/N_0$ (in dB) for a proposed (64,20) code combined with a upper-unitriangular PT matrix, where the elements above the main diagonal are chosen randomly from the set {0,1}, under SCL decoding with various list sizes L is compared to the CRC-aided polar codes of 5G standard. The PT-Proposed codes with list lengths 4, 8 and 16 correspond polar codes as herein disclosed.

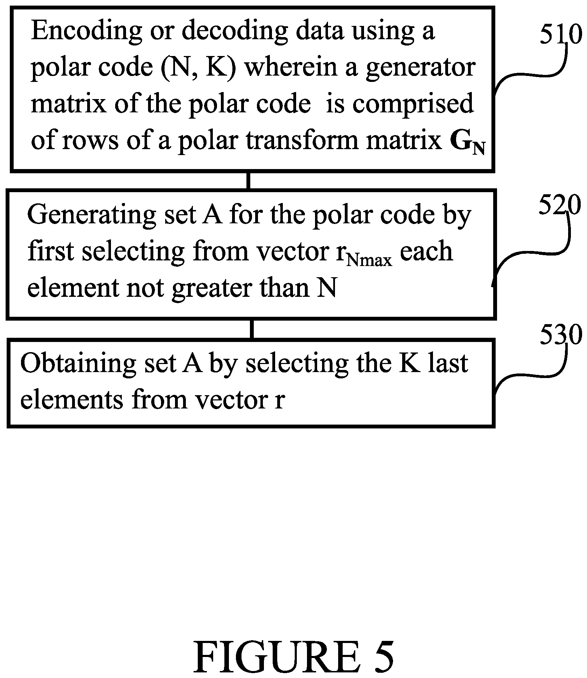

FIGURE 5 is a flow graph of a method in accordance with at least some embodiments of the present invention. Phase 510 comprises encoding or decoding data using a polar code, wherein a generator matrix of the polar code is comprised of rows of a polar transform matrix $G_N = B_N G_2^{\otimes n}$, where $B_N$; is an N × N bit-reversal matrix, where N = $2^n$ is a non-negative integer and where $G_2^{\otimes n}$ is an n-fold Kronecker product of $G_2 \triangleq \begin{bmatrix} 1 & 0 \\ 1 & 1 \end{bmatrix}$, a set of indices of rows of the polar transform matrix which form the generator matrix being set A. Phase 520 comprises generating set A for the polar code with N encoded bits, N not greater than 128, and K payload bits by selecting from vector $r_{N_{max}}$ = [1, 65, 33, 17, 9, 5, 3, 2, 97, 81, 73, 69, 67, 66, 49, 41, 37, 35, 34, 25, 21, 19, 18, 13, 11, 10, 7, 6, 4, 113, 105, 101, 99, 98, 89, 85, 83, 82, 77, 75, 74, 71, 70, 68, 57, 53, 51, 50, 45, 43, 42, 39, 38, 36, 29, 27, 26, 23, 22, 20, 15, 14, 12, 8, 121, 117, 115, 114, 109, 107, 106, 103, 102, 100, 93, 91, 90, 87, 86, 84, 79, 78, 76, 72, 61, 59, 58, 55, 54, 52, 47, 46, 44, 40, 31, 30, 28, 24, 16, 125, 123, 122, 119, 118, 116, 111, 110, 108, 104, 95, 94, 92, 88, 80, 63, 62, 60, 56, 48, 32, 127, 126, 124, 120, 112, 96, 64, 128] each element not greater than N to thereby obtain, while maintaining the order of the selected elements, vector r. Finally, phase 530 comprises obtaining set A by selecting the K last elements from vector r.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

Reference throughout this specification to one embodiment or an embodiment means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment. Where reference is made to a numerical value using a term such as, for example, about or substantially, the exact numerical value is also disclosed.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various embodiments and example of the present invention may be referred to herein along with alternatives for the various components thereof. It is understood that such embodiments, examples, and alternatives are not to be construed as de facto equivalents of one another, but are to be considered as separate and autonomous representations of the present invention.

Furthermore, the described features, structures, or characteristics may be combined in any suitable manner in one or more embodiments. In the preceding description, numerous specific details are provided, such as examples of lengths, widths, shapes, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

While the forgoing examples are illustrative of the principles of the present invention in one or more particular applications, it will be apparent to those of ordinary skill in the art that numerous modifications in form, usage and details of implementation can be made without the exercise of inventive faculty, and without departing from the principles and concepts of the invention. Accordingly, it is not intended that the invention be limited, except as by the claims set forth below.

The verbs "to comprise" and "to include" are used in this document as open limitations that neither exclude nor require the existence of also un-recited features. The features recited in depending claims are mutually freely combinable unless otherwise explicitly stated. Furthermore, it is to be understood that the use of "a" or "an", that is, a singular form, throughout this document does not exclude a plurality.

As used herein, "at least one of the following: <a list of two or more elements>" and "at least one of <a list of two or more elements>" and similar wording, where the list of two or more elements are joined by "and" or "or", mean at least any one of the elements, or at least any two or more of the elements, or at least all the elements.

INDUSTRIAL APPLICABILITY

At least some embodiments of the present invention find industrial application in channel coding for communication.

ACRONYMS LIST

3GPP    $3^{rd}$ Generation Partnership Project, 3GPP
SCL    successive cancellation list

**Claims**

1. An apparatus comprising at least one processing core and at least one memory storing instructions that, when executed by the at least one processing core, cause the apparatus at least to:

    - encode or decode data using a polar code, wherein a generator matrix of the polar code is comprised of rows of a polar transform matrix $G_N = B_N G_2^{\otimes n}$, where $B_N$ ;is an $N \times N$ bit-reversal matrix, where $N = 2^n$ is a non-

    negative integer and where $G_2^{\otimes n}$ is an n-fold Kronecker product of $G_2 \triangleq \begin{bmatrix} 1 & 0 \\ 1 & 1 \end{bmatrix}$;
    - a set of indices of rows of the polar transform matrix which form the generator matrix being set A,
    - wherein at least one of the following applies:

        o A) for encoded length N = 64 with 44 payload bits the set A is {4, 6, 8, 12, 14, 15, 16, 20, 22, 23, 24, 26, 27, 28, 29, 30, 31, 32, 36, 38, 39, 40, 42, 43, 44, 45, 46, 47, 48, 50, 51, 52, 53, 54, 55, 56, 57, 58, 59, 60, 61, 62, 63, 64},
        o B) for encoded length N = 64 with 20 payload bits the set A is {16, 24, 28, 30, 31, 32, 40, 44, 46, 47, 48, 52, 54, 55, 56, 58, 60, 62, 63, 64}, and
        o C) for encoded length N = 32 with 20 payload bits the set A is {8, 12, 14, 15, 16,24,28,30,31,32}.

2. The apparatus according to claim 1, wherein the apparatus is configured to perform the encoding, and an encoder of the apparatus is configured to use an upper-unitriangular NxN pre-transformation matrix before the polar transformation and to place the data to be encoded in subvector u_A defined by the indices of the set A and elements of subvector u_F are set to zeroes.

3. The apparatus according to claim 1 or 2, wherein the apparatus comprises, or is comprised in, a user equipment, the data is uplink data and the apparatus is configured to encode the data for transmission.

4. The apparatus according to claim 1, wherein the apparatus comprises, or is comprised in, a base station, the data is downlink data and the apparatus is configured to encode the data for transmission.

5. The apparatus according to any of claims 1 - 4, wherein the apparatus is configured to store plural of the sets A in a nested manner.

6. The apparatus according to claim 5, wherein the storing in the nested manner comprises use of an integer vector.

7. The apparatus according to any of claims 1 - 6, wherein the apparatus is configured to perform the encoding such that the encoding comprises a pre-transformation using an upper-triangular pre-transformaton matrix T.

8. The apparatus according to any of claims 1-7, wherein each one of A), B) and C) applies.

9. The apparatus according to any of claims 1-7, wherein exactly one of A), B) and C) does not apply and exactly two of A), B) and C) do apply.

10. The apparatus according to any of claims, wherein configured to employ, in the encoding, precoding defined by a KxN binary matrix P before the NxN polar transformation, where P satisfies the following:

   A) the collection of column indices of the first "1" in each row constitutes set A,
   B) if the column index of the first "1" in row i is larger than that of the first "1" in row j, then i>j, and
   C) the apparatus is configured to perform the encoding by multiplying a K-bit message with matrix P followed by a length-N polar transform.

11. An apparatus comprising at least one processing core and at least one memory storing instructions that, when executed by the at least one processing core, cause the apparatus at least to:

   - encode or decode data using a polar code, wherein a generator matrix of the polar code is comprised of rows of a polar transform matrix $G_N = B_N G_2^{\otimes n}$, where $B_N$ ;is an $N \times N$ bit-reversal matrix, where N = $2^n$ is a non-negative integer and where $G_2^{\otimes n}$ is an n-fold Kronecker product of $G_2 \triangleq \begin{bmatrix} 1 & 0 \\ 1 & 1 \end{bmatrix}$;
   - a set of indices of rows of the polar transform matrix which form the generator matrix being set A, wherein the apparatus is configured to generate set A for the polar code with N encoded bits, N not greater than 128, and K payload bits as follows:

   ◦ select from vector r_Nmax = [1, 65, 33, 17, 9, 5, 3, 2, 97, 81, 73, 69, 67, 66, 49, 41, 37, 35, 34, 25, 21, 19, 18, 13, 11, 10, 7, 6, 4, 113, 105, 101, 99, 98, 89, 85, 83, 82, 77, 75, 74, 71, 70, 68, 57, 53, 51, 50, 45, 43, 42, 39, 38, 36, 29, 27, 26, 23, 22, 20, 15, 14, 12, 8, 121, 117, 115, 114, 109, 107, 106, 103, 102, 100, 93, 91, 90, 87, 86, 84, 79, 78, 76, 72, 61, 59, 58, 55, 54, 52, 47, 46, 44, 40, 31, 30, 28, 24, 16, 125, 123, 122, 119, 118, 116, 111, 110, 108, 104, 95, 94, 92, 88, 80, 63, 62, 60, 56, 48, 32, 127, 126, 124, 120, 112, 96, 64, 128] each element not greater than N to thereby obtain, while maintaining the order of the selected elements, vector r;
   ◦ obtain set A by selecting the K last elements from vector r.

12. A method comprising:

   - encoding or decoding data using a polar code, wherein a generator matrix of the polar code is comprised of rows of a polar transform matrix $G_N = B_N G_2^{\otimes n}$, where $B_N$ ;is an $N \times N$ bit-reversal matrix, where N = $2^n$ is a non-negative integer and where $G_2^{\otimes n}$ is an n-fold Kronecker product of $G_2 \triangleq \begin{bmatrix} 1 & 0 \\ 1 & 1 \end{bmatrix}$;
   - a set of indices of rows of the polar transform matrix which form the generator matrix being set A,
   - wherein at least one of the following applies:

   o A) for encoded length N = 64 with 44 payload bits the set A is {4, 6, 8, 12, 14, 15, 16, 20, 22, 23, 24, 26, 27, 28, 29, 30, 31, 32, 36, 38, 39, 40, 42, 43, 44, 45, 46, 47, 48, 50, 51, 52, 53, 54, 55, 56, 57, 58, 59, 60, 61, 62, 63, 64},
   o B) for encoded length N = 64 with 20 payload bits the set A is {16, 24, 28, 30, 31, 32, 40, 44, 46, 47, 48, 52, 54, 55, 56, 58, 60, 62, 63, 64}, and
   o C) for encoded length N = 32 with 20 payload bits the set A is {8, 12, 14, 15, 16,24,28,30,31,32}.

13. A method, comprising:

   - encoding or decoding data using a polar code, wherein a generator matrix of the polar code is comprised of rows of a polar transform matrix $G_N = B_N G_2^{\otimes n}$, where $B_N$ ;is an $N \times N$ bit-reversal matrix, where N = $2^n$ is a non-negative integer and where $G_2^{\otimes n}$ is an n-fold Kronecker product of $G_2 \triangleq \begin{bmatrix} 1 & 0 \\ 1 & 1 \end{bmatrix}$;
   - a set of indices of rows of the polar transform matrix which form the generator matrix being set A, wherein the apparatus is configured to generate set A for the polar code with N encoded bits, N not greater than 128, and K payload bits as follows:

○ select from vector $r_{N_{max}}$ = [1, 65, 33, 17, 9, 5, 3, 2, 97, 81, 73, 69, 67, 66, 49, 41, 37, 35, 34, 25, 21, 19, 18, 13, 11, 10, 7, 6, 4, 113, 105, 101, 99, 98, 89, 85, 83, 82, 77, 75, 74, 71, 70, 68, 57, 53, 51, 50, 45, 43, 42, 39, 38, 36, 29, 27, 26, 23, 22, 20, 15, 14, 12, 8, 121, 117, 115, 114, 109, 107, 106, 103, 102, 100, 93, 91, 90, 87, 86, 84, 79, 78, 76, 72, 61, 59, 58, 55, 54, 52, 47, 46, 44, 40, 31, 30, 28, 24, 16, 125, 123, 122, 119, 118, 116, 111, 110, 108, 104, 95, 94, 92, 88, 80, 63, 62, 60, 56, 48, 32, 127, 126, 124, 120, 112, 96, 64, 128] each element not greater than N to thereby obtain, while maintaining the order of the selected elements, vector r;
○ obtain set A by selecting the K last elements from vector r.

**14.** An apparatus comprising means for:

- encoding or decoding data using a polar code, wherein a generator matrix of the polar code is comprised of rows of a polar transform matrix $G_N = B_N G_2^{\otimes n}$, where $B_N$ ;is an N × N bit-reversal matrix, where N = $2^n$ is a non-negative integer and where $G_2^{\otimes n}$ is an n-fold Kronecker product of $G_2 \triangleq \begin{bmatrix} 1 & 0 \\ 1 & 1 \end{bmatrix}$ ;
- a set of indices of rows of the polar transform matrix which form the generator matrix being set A,
- wherein at least one of the following applies:

o A) for encoded length N = 64 with 44 payload bits the set A is {4, 6, 8, 12, 14, 15, 16, 20, 22, 23, 24, 26, 27, 28, 29, 30, 31, 32, 36, 38, 39, 40, 42, 43, 44, 45, 46, 47, 48, 50, 51, 52, 53, 54, 55, 56, 57, 58, 59, 60, 61, 62, 63, 64},
o B) for encoded length N = 64 with 20 payload bits the set A is {16, 24, 28, 30, 31, 32, 40, 44, 46, 47, 48, 52, 54, 55, 56, 58, 60, 62, 63, 64}, and
o C) for encoded length N = 32 with 20 payload bits the set A is {8, 12, 14, 15, 16,24,28,30,31,32}.

**15.** A non-transitory computer readable medium having stored thereon a set of computer readable instructions that, when executed by at least one processor, cause an apparatus to at least:

- encode or decode data using a polar code, wherein a generator matrix of the polar code is comprised of rows of a polar transform matrix $G_N = B_N G_2^{\otimes n}$, where $B_N$ ;is an N × N bit-reversal matrix, where N = $2^n$ is a non-negative integer and where $G_2^{\otimes n}$ is an n-fold Kronecker product of $G_2 \triangleq \begin{bmatrix} 1 & 0 \\ 1 & 1 \end{bmatrix}$ ;
- a set of indices of rows of the polar transform matrix which form the generator matrix being set A,
- wherein at least one of the following applies:

o A) for encoded length N = 64 with 44 payload bits the set A is {4, 6, 8, 12, 14, 15, 16, 20, 22, 23, 24, 26, 27, 28, 29, 30, 31, 32, 36, 38, 39, 40, 42, 43, 44, 45, 46, 47, 48, 50, 51, 52, 53, 54, 55, 56, 57, 58, 59, 60, 61, 62, 63, 64},
o B) for encoded length N = 64 with 20 payload bits the set A is {16, 24, 28, 30, 31, 32, 40, 44, 46, 47, 48, 52, 54, 55, 56, 58, 60, 62, 63, 64}, and
o C) for encoded length N = 32 with 20 payload bits the set A is {8, 12, 14, 15, 16,24,28,30,31,32}.

FIGURE 1

## FIGURE 2A

## FIGURE 2B

## FIGURE 2C

**FIGURE 3**

FIGURE 4

Encoding or decoding data using a polar code (N, K) wherein a generator matrix of the polar code is comprised of rows of a polar transform matrix $\mathbf{G_N}$ — 510

Generating set A for the polar code by first selecting from vector $r_{Nmax}$ each element not greater than N — 520

Obtaining set A by selecting the K last elements from vector r — 530

# FIGURE 5

Europäisches
Patentamt

European
Patent Office

Office européen
des brevets

# EUROPEAN SEARCH REPORT

Application Number

EP 23 18 4235

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2018/113705 A1 (HUAWEI TECH CO LTD [CN]) 28 June 2018 (2018-06-28) <br> * paragraph [0039] – paragraph [0042] * <br> * paragraph [0073] – paragraph [0076] * <br> * paragraph [0098] – paragraph [0103] * <br> * paragraph [0106] – paragraph [0108] * <br> * figures 1,2,16-19 * | 1-15 | INV. <br> H03M13/13 |
| A | WO 2018/143773 A1 (LG ELECTRONICS INC [KR]) 9 August 2018 (2018-08-09) <br> * paragraph [0084] – paragraph [0090] * <br> * paragraph [0120] – paragraph [0138] * | 1-15 | |
| A | EP 3 873 010 A1 (HUAWEI TECH CO LTD [CN]) 1 September 2021 (2021-09-01) <br> * paragraph [0051] – paragraph [0054] * <br> * paragraph [0059] – paragraph [0069] * <br> * paragraph [0073] – paragraph [0075] * <br> * figures 2,5,7,9 * | 1-15 | |
| A | NOKIA ET AL: "Sequence design for Polar codes", <br> 3GPP DRAFT; R1-1711542_SEQUENCE DESIGN FOR POLAR, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE <br> , <br> vol. RAN WG1, no. Qingdao, P.R. China; 20170627 – 20170630 <br> 19 June 2017 (2017-06-19), XP051305709, <br> Retrieved from the Internet: <br> URL:http://www.3gpp.org/ftp/tsg_ran/WG1_RL 1/TSGR1_AH/NR_AH_1706/Docs/ <br> [retrieved on 2017-06-19] <br> * page 11 * | 1-15 | TECHNICAL FIELDS SEARCHED (IPC) <br><br> H03M <br> H04L |

-/--

The present search report has been drawn up for all claims

| Place of search | Date of completion of the search | Examiner |
|---|---|---|
| Munich | 8 November 2023 | Burkert, Frank |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

## EUROPEAN SEARCH REPORT

Application Number

EP 23 18 4235

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2019/012457 A1 (ERICSSON TELEFON AB L M [SE]) 17 January 2019 (2019-01-17) * paragraph [0007] – paragraph [0012] * ----- | 1-15 | |
| A | LI YUAN ET AL: "On the Weight Spectrum Improvement of Pre-transformed Reed-Muller Codes and Polar Codes", 2023 IEEE INTERNATIONAL SYMPOSIUM ON INFORMATION THEORY (ISIT), IEEE, 25 June 2023 (2023-06-25), pages 2153-2158, XP034404369, DOI: 10.1109/ISIT54713.2023.10206539 [retrieved on 2023-08-22] * abstract * * sections II and III * ----- | 1-15 | |
| A | BIN LI ET AL: "Performance of CRC Concatenated Pre-transformed RM-Polar Codes", ARXIV.ORG, CORNELL UNIVERSITY LIBRARY, 201 OLIN LIBRARY CORNELL UNIVERSITY ITHACA, NY 14853, 15 April 2021 (2021-04-15), XP081938598, * abstract * * page 1, right-hand column * ----- | 1-15 | TECHNICAL FIELDS SEARCHED (IPC) |

The present search report has been drawn up for all claims

| Place of search | Date of completion of the search | Examiner |
|---|---|---|
| Munich | 8 November 2023 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 23 18 4235

This annex lists the patent family members relating to the patent documents cited in the above-mentioned European search report.
The members are as contained in the European Patent Office EDP file on
The European Patent Office is in no way liable for these particulars which are merely given for the purpose of information.

08-11-2023

| Patent document cited in search report | | | Publication date | Patent family member(s) | | | Publication date |
|---|---|---|---|---|---|---|---|
| WO 2018113705 | A1 | | 28-06-2018 | BR | 112019012985 | A2 | 03-12-2019 |
| | | | | CN | 110089037 | A | 02-08-2019 |
| | | | | EP | 3549265 | A1 | 09-10-2019 |
| | | | | JP | 2020504508 | A | 06-02-2020 |
| | | | | US | 2018183464 | A1 | 28-06-2018 |
| | | | | WO | 2018113705 | A1 | 28-06-2018 |
| WO 2018143773 | A1 | | 09-08-2018 | NONE | | | |
| EP 3873010 | A1 | | 01-09-2021 | CN | 111200476 | A | 26-05-2020 |
| | | | | CN | 114172617 | A | 11-03-2022 |
| | | | | EP | 3873010 | A1 | 01-09-2021 |
| | | | | US | 2021328599 | A1 | 21-10-2021 |
| | | | | US | 2023098837 | A1 | 30-03-2023 |
| | | | | WO | 2020098461 | A1 | 22-05-2020 |
| WO 2019012457 | A1 | | 17-01-2019 | EP | 3652865 | A1 | 20-05-2020 |
| | | | | US | 2021111739 | A1 | 15-04-2021 |
| | | | | WO | 2019012457 | A1 | 17-01-2019 |

EPO FORM P0459

For more details about this annex : see Official Journal of the European Patent Office, No. 12/82